(19) Europäisches Patentamt
European Patent Office
Office européen des brevets

(11) EP 3 392 298 A1

(12) # EUROPEAN PATENT APPLICATION
published in accordance with Art. 153(4) EPC

(43) Date of publication:
**24.10.2018 Bulletin 2018/43**

(21) Application number: **16875259.0**

(22) Date of filing: **27.10.2016**

(51) Int Cl.:
***C08J 9/08*** *(2006.01)* ***B29C 44/00*** *(2006.01)*
***C08G 18/32*** *(2006.01)* ***C08L 101/00*** *(2006.01)*
***C08G 101/00*** *(2006.01)*

(86) International application number:
**PCT/JP2016/081845**

(87) International publication number:
**WO 2017/104274 (22.06.2017 Gazette 2017/25)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **17.12.2015 JP 2015246665**

(71) Applicant: **TOYO TIRE & RUBBER CO., LTD.**
**Itami-shi**
**Hyogo 664-0847 (JP)**

(72) Inventor: **ISEKI, Seiji**
**Itami-shi**
**Hyogo 6640847 (JP)**

(74) Representative: **Cabinet Beau de Loménie**
**158, rue de l'Université**
**75340 Paris Cedex 07 (FR)**

(54) **THERMORESPONSIVE MATERIAL, METHOD FOR PRODUCING THERMORESPONSIVE MATERIAL, AND HEAT CONTROL DEVICE**

(57) Provided is a thermoresponsive material containing bubbles and has improved durability. A thermoresponsive material 1 whose state changes, depending on a change in temperature, comprises a matrix 2 in which bubbles 4 having an average diameter of 30 to 400 μm are dispersed. Satisfied is $D/a \leq 0.7$, where D represents the standard deviation of diameters of the bubbles 4, and a represents the average diameter of the bubbles 4. Satisfied is $0.3 \leq V_1/V_2 \leq 0.9$, where $V_1$ represents the volume of the bubbles 4 at room temperature, and $V_2$ represents the apparent volume of the matrix 2 at room temperature. The matrix 2 contains a liquid crystalline polyurethane.

[FIG. 2]

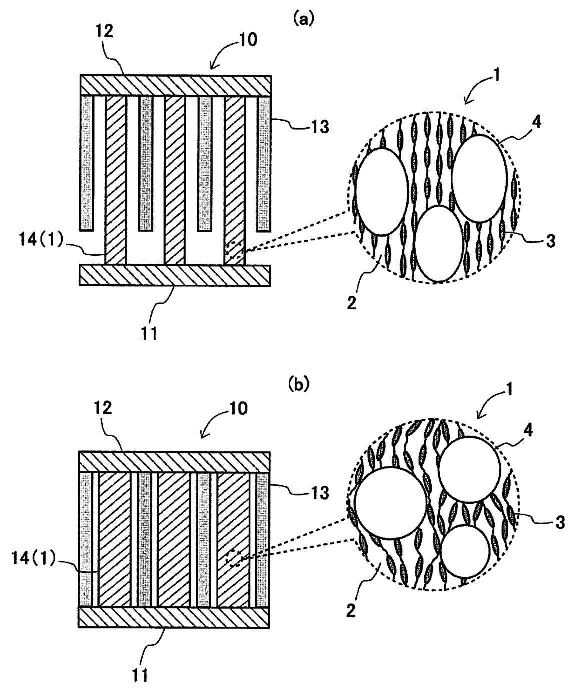


EP 3 392 298 A1

## Description

### TECHNICAL FIELD

The present invention relates to thermoresponsive materials that change their states, depending on a change in temperature, methods for producing such thermoresponsive materials, and heat control devices employing such thermoresponsive materials.

### BACKGROUND ART

In recent years, actuators, etc., have been developed that are formed of a deformable polymer material containing a liquid crystalline component, and utilize changes in their shapes caused by the phase transition of the liquid crystal.

As an example of a conventional actuator that employs a polymer material, a stimulus-responsive deformable material (thermoresponsive material) has been proposed that undergoes deformation which converts thermal energy into a mechanical output, and can have a lower weight and a smaller volume (see, for example, Patent Document 1). The stimulus-responsive deformable material disclosed in Patent Document 1 is formed of a polymer material that has voids, and contains a liquid crystal that serves as a drive source in the framework thereof excluding the voids.

### CITATION LIST

### PATENT LITERATURE

Patent Document 1: International Publication WO2006/134697

### SUMMARY OF INVENTION

### TECHNICAL PROBLEM

Materials for actuators, etc., are required to have high durability so that they can withstand repetitive temperature change, deformation, and loading. In this regard, the stimulus-responsive deformable material disclosed in Patent Document 1 includes a polymer material having voids. Patent Document 1 indicates that the voids in the polymer material are preferably large open bubbles so that the voids are in air communication with the outside. However, when such a polymer material having large open bubbles is used in an actuator, etc., the bubbles are likely to be broken due to repetitive temperature change, deformation, loading, etc., or initiate the rupture of the material, etc., so that the actuator, etc., does not return to its pre-deformed shape, i.e., the durability of the actuator is likely to decrease.

As described above, for the thermoresponsive materials for use in actuators, etc., no technologies for inhibiting the decrease of the durability of the material containing bubbles have yet been sufficiently established, and there is room for improvement in the thermoresponsive materials in order to increase their applications. With this in mind, the present invention has been made. It is an object of the present invention to provide a thermoresponsive material containing bubbles and having improved durability, a method for producing the thermoresponsive material, and a heat control device employing the thermoresponsive material.

### SOLUTION TO PROBLEM

To achieve the above object, the present invention provides a thermoresponsive material whose state changes, depending on a change in temperature, comprising:
a matrix in which bubbles having an average diameter of 30 to 400 $\mu$m are dispersed.

In general, bubbles contained in a material (object) can impart various properties to the material. For thermoresponsive materials, to identify the state of bubbles in the matrix greatly assists in designing the thermoresponsive materials. Therefore, in order to develop a novel thermoresponsive material in which bubbles are dispersed in the matrix, the present inventors have paid attention particularly to the sizes of the bubbles, and have varied the average diameter of the bubbles to search for a thermoresponsive material that achieves the object of the present invention.

In the thermoresponsive material having the above feature, the bubbles dispersed in the matrix have an average diameter within the range of 30 to 400 $\mu$m. Such bubbles have a small bubble volume and bubble surface area, and therefore, are less likely to be affected by buoyancy, shear stress, compressive stress, and the like in the matrix. Therefore, even when external stress is applied to the thermoresponsive material, the bubbles in the matrix do not initiate the rupture of the thermoresponsive material, and the bubbles can remain in the matrix over a long period of time. The thermoresponsive material containing such bubbles has properties such as heat insulating properties attributed to the bubbles, and is maintained stable over a long period of time, and therefore, is useful as a highly durable material.

In the thermoresponsive material of the present invention,

$D/a \leq 0.7$ is preferably satisfied,

where D represents the standard deviation of diameters of the bubbles, and a represents the average diameter of the bubbles.

In the thermoresponsive material having the above feature, the relationship between the standard deviation and the average of the diameters of the bubbles contained in the thermoresponsive material falls within the above range. Therefore, variations in bubble size of the thermoresponsive material are small. Therefore, even when external stress is applied to the thermoresponsive material, the stress can be borne by the entire thermoresponsive material. Therefore, stress is not concentrated at a specific position of the thermoresponsive material, and therefore, the bubbles can be prevented from initiating the rupture of the matrix.

In the thermoresponsive material of the present invention,

$0.3 \leq V_1/V_2 \leq 0.9$ is preferably satisfied,

where $V_1$ represents the volume of the bubbles at room temperature, and $V_2$ represents the apparent volume of the matrix at room temperature.

In the thermoresponsive material having the above feature, $V_1/V_2$, i.e., a void rate, is within the above range. Therefore, the thermoresponsive material can have well-balanced heat insulating properties and strength (durability).

In the thermoresponsive material of the present invention,

the matrix preferably contains a liquid crystalline polyurethane.

The thermoresponsive material having the above feature contains a liquid crystalline polyurethane. Therefore, the matrix has both liquid crystallinity and elasticity attributed to the liquid crystalline polyurethane. In particular, the thermoresponsive material can be used as a thermoresponsive elastic material that is reversibly expandable in response to a change in temperature.

In the thermoresponsive material of the present invention, the liquid crystalline polyurethane preferably has mesogen groups aligned by stretching, and when the temperature of the liquid crystalline polyurethane exceeds a phase transition temperature (Ti) of the liquid crystalline polyurethane, the mesogen groups are preferably disaligned, and the liquid crystalline polyurethane preferably contracts in a stretching direction, and when the temperature of the liquid crystalline polyurethane is less than the phase transition temperature (Ti), the mesogen groups are preferably realigned, and the liquid crystalline polyurethane preferably expands in the stretching direction.

In the thermoresponsive material having the above feature, the liquid crystalline polyurethane has mesogen groups aligned by stretching. Therefore, by utilizing the phase transition (a change in the aligned state of the mesogen groups) of the liquid crystalline polyurethane, the thermoresponsive material can be used as a thermoresponsive elastic material that is reversibly expandable in response to a change in temperature.

To achieve the above object, the present invention provides a method for producing a thermoresponsive material whose state changes, depending on a change in temperature, the method comprising:

a bubble generation step of adding a pyrolytic blowing agent to a liquid crystalline polyol that has or has not been melted by heating, the weight ratio of the pyrolytic blowing agent to the liquid crystalline polyol being 0.02 to 0.20 times, and adding an isocyanate compound to the liquid crystalline polyol that has been melted by heating, the weight ratio of the isocyanate compound to the liquid crystalline polyol being 0.15 to 0.45 times, to generate bubbles in the melt of the liquid crystalline polyol; and

a cooling step of cooling the melt containing the bubbles to form a liquid crystalline polyurethane.

In the thermoresponsive material production method having the above feature, a suitable amount of a pyrolytic blowing agent is added to a liquid crystalline polyol that has or has not been melted by heating, and a suitable amount of an isocyanate compound is added to the liquid crystalline polyol that has been melted by heating, whereby the pyrolytic blowing agent is caused to generate bubbles. As a result, bubbles having a suitable average diameter are provided in the melt, and a thermoresponsive material in which bubbles having an average diameter of 30 to 400 $\mu$m are dispersed in the matrix can eventually be produced.

The thermoresponsive material production method of the present invention, further preferably comprises:

an alignment step of aligning mesogen groups contained in the liquid crystalline polyurethane; and

an aging step of maintaining an aligned state of the mesogen groups.

In the thermoresponsive material production method having the above feature, the liquid crystalline polyurethane formed by cooling the melt is aligned and then directly aged, and therefore, a thermoresponsive elastic material that is reversibly expandable in response to a change in temperature can be obtained.

In the thermoresponsive material production method of the present invention,
in the bubble generation step, sodium hydrogen carbonate is preferably added as the pyrolytic blowing agent.

In the thermoresponsive material production method having the above feature, sodium hydrogen carbonate is used as the pyrolytic blowing agent, and therefore, bubbles having substantially a uniform average diameter can be easily dispersed in the matrix. The thermoresponsive material having the bubbles thus obtained has further improved durability.

To achieve the above object, the present invention provides a heat control device. The heat control device preferably comprises the above thermoresponsive material.

The heat control device having the above feature contains the above thermoresponsive material, and therefore, has excellent thermoresponsiveness. The above thermoresponsive material also has excellent durability, and therefore, the heat control device having the above feature can be used as an actuator for a heat dissipation member.

The heat control device of the present invention preferably comprises:

a heat conductive member configured to be brought into contact with or separated from an object to be heat-controlled;
a heat dissipation plate configured to receive heat transferred from the object to the heat conductive member, and dissipate the heat to the outside;
a support member provided between the object and the heat dissipation plate, and configured to support the heat dissipation plate and the heat conductive member with respect to the object,
wherein
the support member preferably contains the thermoresponsive material, and is preferably configured such that when the support member contracts in response to a change in temperature, the heat conductive member is brought into contact with the object.

The heat control device having the above feature is configured such that, when the support member containing the thermoresponsive material contracts in response to a change in temperature, the heat conductive member is brought into contact with an object to be heat-controlled. Therefore, the heat conductive member can share stress with the support member. Thus, even if the temperature increase decreases the elasticity modulus or rupture stress of the support member, the decrease can be compensated for by the heat conductive member. As a result, the strength of the entire heat control device can be maintained.

BRIEF DESCRIPTION OF DRAWINGS

[FIG. 1] FIG. 1 is a flowchart showing a method for producing a thermoresponsive material according to the present invention.
[FIG. 2] FIG. 2 is a diagram for describing a heat control device that employs the thermoresponsive material.
[FIG. 3] FIG. 3 shows electron microscopic photographs of representative thermoresponsive materials of the present invention.

DESCRIPTION OF EMBODIMENTS

Embodiments of a thermoresponsive material, thermoresponsive material production method, and heat control device according to the present invention will now be described with reference to the accompanying drawings. Note that the present invention is in no way limited to the embodiments described below or configurations shown in the drawings.

(Composition of Thermoresponsive Material)

The thermoresponsive material of the present invention changes its state, depending on a change in temperature. For example, the thermoresponsive material of the present invention is an elastomer containing a liquid crystalline polymer as a matrix. As used herein, the "matrix" means the main component of the material. Therefore, the thermoresponsive material of the present invention does not exclude the possibility of containing, in addition to the main component, a small amount of a sub-component or sub-components (e.g., other polymers, low-molecular-weight substances, fillers, etc.).

Examples of the liquid crystalline polymer as the matrix include liquid crystalline polyurethanes, liquid crystalline silicone resins, liquid crystalline acrylate resins, liquid crystalline poly-N-substituted (meth)acrylamides, liquid crystalline polyvinylethers, and the like. Of them, liquid crystalline polyurethanes, which are a liquid crystalline elastomer having both liquid crystallinity and elasticity, are easily processed into fiber, film, foam, and the like. Liquid crystalline polyurethanes are preferably used as the matrix of the thermoresponsive material of the present invention. Therefore, in the embodiments below, the thermoresponsive material that contains a liquid crystalline polyurethane as the liquid crystalline polymer is particularly illustrated.

A liquid crystalline polyurethane is produced by reacting a mesogen group-containing compound having an active hydrogen group (hereinafter simply referred to as a "mesogen group-containing compound"), an isocyanate compound, an alkylene oxide and/or a styrene oxide, and a cross-linking agent together.

As the mesogen group-containing compound, a compound represented by general formula (1) below is used, for example.

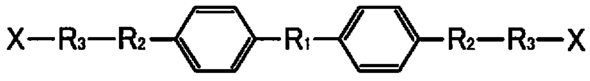 (1)

In general formula (1), X represents an active hydrogen group, $R_1$ represents a single bond, -N=N-, -CO-, -CO-O-, or - CH=N-, $R_2$ represents a single bond or -O-, and $R_3$ represents a single bond or an alkylene group having 1 to 20 carbon atoms. Note that those in which $R_2$ represents -O- and $R_3$ represents a single bond are excluded. Examples of X include OH, SH, $NH_2$, COOH, secondary amines, and the like.

As the isocyanate compound, a diisocyanate compound or a trifunctional or higher-functional isocyanate compound can be used, for example. Examples of the diisocyanate compound include: aromatic diisocyanates, such as 2,4-toluene diisocyanate, 2,6-toluene diisocyanate, 2,2'-diphenylmethane diisocyanate, 2,4'-diphenylmethane diisocyanate, 4,4'-diphenylmethane diisocyanate, 1,5-naphthalene diisocyanate, p-phenylene diisocyanate, m-phenylene diisocyanate, p-xylylene diisocyanate, and m-xylylene diisocyanate; aliphatic diisocyanates, such as ethylene diisocyanate, 2,2,4-trimethylhexamethylene-1,6-diisocyanate, 2,4,4-trimethylhexamethylene-1,6-diisocyanate, and 1,6-hexamethylene diisocyanate; and alicyclic diisocyanates, such as 1,4-cyclohexane diisocyanate, 4,4'-dicyclohexylmethane diisocyanate, isophorone diisocyanate, and norbornane diisocyanate. These diisocyanate compounds may be used alone or in combination. Examples of the trifunctional or higher-functional isocyanate compound include: triisocyanates, such as triphenylmethane triisocyanate, tris(isocyanatophenyl)thiophosphate, lysine ester triisocyanate, 1,3,6-hexamethylene triisocyanate, 1,6,11-undecane triisocyanate, 1,8-diisocyanate-4-isocyanatomethyl octane, and bicycloheptane triisocyanate; and tetraisocyanates, such as tetraisocyanatesilane. These trifunctional or higher-functional isocyanate compounds may be used alone or in combination. As the isocyanate compound, a mixture of the above diisocyanate compounds and the above trifunctional or higher-functional isocyanate compounds can be used. The blended amount of the isocyanate compound is adjusted to 10 to 40 wt%, preferably 15 to 30 wt%, with respect to all the raw materials for the liquid crystalline polyurethane. If the blended amount of the isocyanate compound is less than 10 wt%, polymerization by a urethane reaction is insufficient, so that it is difficult to continuously mold the liquid crystalline polyurethane. If the blended amount of the isocyanate compound exceeds 40 wt%, the blended amount of the mesogen group-containing compound is relatively small with respect to all the raw materials, and therefore, the liquid crystallinity of the liquid crystalline polyurethane decreases.

As the alkylene oxide, ethylene oxide, propylene oxide, or butylene oxide can be used, for example. These alkylene oxides may be used alone or in combination. The styrene oxide may be those that have a substituent, such as an alkyl group, an alkoxyl group, or halogen, on the benzene ring. The alkylene oxide may be a mixture of the above alkylene oxides and the above styrene oxides. The blended amount of the alkylene oxide and/or the styrene oxide is adjusted such that 1 to 10 mol, preferably 1 to 6 mol, of the alkylene oxide and/or the styrene oxide is added with respect to one mol of the mesogen group-containing compound. If the number of moles of the alkylene oxide and/or styrene oxide added is less than one mol, it is difficult to sufficiently decrease the temperature range within which the liquid crystalline polyurethane has liquid crystallinity, and therefore, it is difficult to continuously mold the liquid crystalline polyurethane while reacting and curing the raw materials in the absence of a solvent and with the liquid crystallinity occurring. If the number of moles of the alkylene oxide and/or styrene oxide added exceeds 10 mol, the liquid crystalline polyurethane is likely to have difficulty in having liquid crystallinity.

As the cross-linking agent, a polyol having three or more reactive functional groups can be used, for example. If such a polyol is used as the cross-linking agent, a dense matrix is obtained, and therefore, the material can have at least a predetermined strength. Therefore, when the thermoresponsive material transitions from a liquid crystal phase to an isotropic phase, the decrease in stress of the matrix can be decreased while the thermoresponsiveness is maintained. Examples of the polyol having three or more reactive functional groups include: high-molecular-weight polyols having three or more hydroxy groups (molecular weight: 400 or more), such as polyether polyols, polyester polyols, polycarbonate polyols, and polyester polycarbonate polyols; and low-molecular-weight polyols, such as trimethylolpropane, glycerol, 1,2,6-hexanetriol, pentaerythritol, tetramethylol cyclohexane, methyl glucoside, sorbitol, mannitol, dulcitol, sucrose, 2,2,6,6-tetrakis(hydroxymethyl)cyclohexanol, and triethanolamine. These polyols may be used alone or in combination. The blended amount of the cross-linking agent is adjusted to 0.1 to 20 parts by weight, preferably 0.2 to

18 parts by weight, with respect to a total of 100 parts by weight of all the raw materials (the mesogen group-containing compound, the isocyanate compound, the alkylene oxide and/or styrene oxide, and the cross-linking agent). When the blended amount of the cross-linking agent is within such a range, the mesogen groups can move to an appropriate extent in the liquid crystalline polyurethane, resulting in well-balanced thermoresponsiveness and liquid crystallinity. If the blended amount of the cross-linking agent is less than 0.1 parts by weight, the liquid crystalline polyurethane is not sufficiently cured, and therefore, the matrix itself is likely to flow, resulting in a failure to achieve thermoresponsiveness. If the blended amount of the cross-linking agent exceeds 20 parts by weight, the liquid crystalline polyurethane has an excessively high cross-link density, and therefore, the alignment of the mesogen groups is likely to be inhibited, resulting in difficulty in achieving liquid crystallinity and therefore a failure to achieve thermoresponsiveness.

The liquid crystalline polyurethane is produced by, for example, the following reaction scheme. Initially, the mesogen group-containing compound and the alkylene oxide and/or styrene oxide are reacted together to formulate an adduct between the mesogen group-containing compound and the alkylene oxide and/or styrene oxide (the adduct is hereinafter referred to as the "mesogen diol"). The cross-linking agent and the isocyanate compound are added to the resultant mesogen diol, following by mixing while heating, to obtain a half-cured liquid crystalline urethane compound (pre-polymer). When the half-cured liquid crystalline urethane compound is cured under suitable conditions, the liquid crystalline urethane compound is cured while being polymerized, to form the liquid crystalline polyurethane (elastomer). The liquid crystalline polyurethane is formed into fiber, film, foam, or the like, depending on the application thereof. In this case, when the liquid crystalline polyurethane is formed while being expanded at a temperature that is higher than or equal to the glass transition temperature (Tg) and lower than or equal to the phase transition temperature (Ti) (i.e., a temperature at which liquid crystallinity occurs), the mesogen groups contained in the liquid crystalline polyurethane are moved and highly aligned in the stretching direction. When the expanded liquid crystalline polyurethane is cured, the thermoresponsive material having both liquid crystallinity and elasticity is completed. When the thermoresponsive material is heated, the mesogen groups in the liquid crystalline polyurethane, which are normally aligned in the stretching direction, are disaligned (irregularly oriented), so that the thermoresponsive material contracts in the stretching direction. When the heat is removed, the alignment of the mesogen groups is restored, so that the thermoresponsive material expands in the stretching direction, which is a remarkable thermoresponsive behavior. Note that the alignment properties of the liquid crystalline polyurethane can be evaluated by the degree of alignment of the mesogen groups. The mesogen groups having a higher degree of alignment are more highly aligned in a uniaxial direction. The degree of alignment is calculated on the basis of a predetermined calculation expression having, as parameters, the antisymmetric-stretching-vibrational absorbance (0°, 90°) of an aromatic ether and the symmetric-bending-vibrational absorbance (0°, 90°) of a methyl group, which are measured using a Fourier-transform infrared spectrometer (FT-IR), as described in the section "Method for Producing Thermoresponsive Material" below. To cause a significant elasticity to occur in the thermoresponsive material, the degree of alignment of the liquid crystalline polyurethane is preferably 0.05 or more, more preferably 0.1 or more.

The liquid crystalline polyurethane obtained by the above reaction scheme can be directly used as the matrix of the thermoresponsive material of the present invention. Alternatively, a small amount of a sub-component or sub-components may be added to the liquid crystalline polyurethane. Examples of the sub-components that can be added to the liquid crystalline polyurethane include organic fillers, inorganic fillers, reinforcing agents, thickeners, release agents, excipients, coupling agents, flame retardants, flame-resistant agents, pigments, colorants, deodorants, antimicrobial agents, antifungal agents, antistatic agents, UV protective agents, surfactants, and the like. As a sub-component, another polymer or a low-molecular-weight substance can be added. The liquid crystalline polyurethane additionally containing sub-components additionally has the functions of the sub-components, and therefore, can be used in more applications.

(Dispersion of Bubbles in Thermoresponsive Material)

The thermoresponsive material of the present invention is characterized in that bubbles having an average diameter of 30 to 400 μm are dispersed in the matrix. Such bubbles have a small bubble volume and a small bubble surface area, and therefore, are less likely to be affected by buoyancy, shear stress, compressive stress, and the like, in the matrix. Therefore, even when external stress is applied to the thermoresponsive material, the bubbles in the matrix do not initiate the rupture of the thermoresponsive material, and the bubbles can remain in the matrix over a long period of time. If the average diameter of the bubbles is less than 30 μm, the bubbles are less likely to be swollen or compressed, resulting in a decrease in the elasticity modulus of the thermoresponsive material. If the average diameter of the bubbles exceeds 400 μm, the bubbles are more likely to be affected by external stress, such as shear stress or compressive stress, and the bubbles are more likely to initiate the rupture of the thermoresponsive material. The thermoresponsive material containing bubbles having an average diameter within the above range has properties such as heat insulating properties attributed to the bubbles, and is maintained stable over a long period of time, and therefore, is useful as a highly durable material.

The bubbles may be dispersed in the matrix (liquid crystalline polyurethane) by, for example, the following

method. A blowing agent is blended with the raw materials for the liquid crystalline polyurethane so that bubbles are generated during a curing reaction of the liquid crystalline polyurethane. In this case, as the blowing agent, sodium hydrogen carbonate can be used, for example. Alternatively, the bubbles can be dispersed in the matrix by, for example, the following methods: mixing the raw materials for the liquid crystalline polyurethane such that air is incorporated into the raw materials; mechanical frothing for forming bubbles in the matrix; mixing hollow fillers into the raw materials for the liquid crystalline polyurethane so that the hollow fillers are dispersed in the matrix; and the like. The thermoresponsive material in which the bubbles are dispersed in the matrix has heat insulating properties enhanced by the bubbles, and therefore, can be used in an environment in which temperature changes radically. In addition, the presence of the bubbles in the matrix contributes to a decrease in the weight of the thermoresponsive material. Therefore, the thermoresponsive material is suitably applied to, for example, transport machines, such as automobiles.

The thermoresponsive material of the present invention is formed such that D/a is 0.7 or less, where D represents the standard deviation of the diameters of the bubbles, and a represents the average diameter of the bubbles. In this case, variations in size of the bubbles contained in the thermoresponsive material are decreased, and therefore, even when external stress is applied to the thermoresponsive material, the stress can be borne by the entire thermoresponsive material. Therefore, stress is not concentrated at a specific position of the thermoresponsive material, and therefore, the bubbles can be prevented from initiating the rupture of the matrix.

The thermoresponsive material of the present invention is formed such that $0.3 \leq V_1/V_2 \leq 0.9$ is satisfied at room temperature, where $V_1$ represents the volume of the bubbles, and $V_2$ represents the apparent volume of the matrix. The value $V_1/V_2$ represents the proportion of the bubbles to the matrix, which is equivalent to the void rate of the thermoresponsive material. When the void rate is within the above suitable range, the thermoresponsive material has well-balanced heat insulating properties and strength (durability). If the value $V_1/V_2$ is less than 0.3, the proportion of gas is low, and therefore, the thermoresponsive material has low heat insulating properties. In addition, the low proportion of gas, the volume of which is easily changed, results in low elasticity. If $V_1/V_2$ exceeds 0.9, the volume of the bubbles in the matrix is large, and therefore, the thermoresponsive material is easily affected by buoyancy, shear stress, compressive stress, and the like. As a result, when external stress is repeatedly applied to the thermoresponsive material, the bubbles easily initiate the rupture of the matrix, resulting in a decrease in the durability of the thermoresponsive material.

(Method for Producing Thermoresponsive Material)

FIG. 1 is a flowchart showing a method for producing the thermoresponsive material according to the present invention. The symbol "S" attached to each block means a step. The method for producing the thermoresponsive material includes a bubble generation step (S1, S2) and a cooling step (S3), and in addition, an alignment step (S4) and an aging step (S5). Each step in the method for producing the thermoresponsive material will now be described.

<Bubble Generation Step>

Initially, the bubble generation step (S1, S2) is executed. In the bubble generation step (S1, S2), a liquid crystalline polyol containing a mesogen group (also hereinafter referred to as a "liquid crystalline polyol") is melted by heating (S1). At this time, a pyrolytic blowing agent is added. As the pyrolytic blowing agent, sodium hydrogen carbonate is preferably used, which facilitates dispersion of bubbles having substantially a uniform diameter in the matrix. The thermoresponsive material in which the substantially uniform bubbles are dispersed in the matrix has improved durability and heat insulating properties, and therefore, may be useful for various applications.

As shown in FIG. 1, the pyrolytic blowing agent is added to the liquid crystalline polyol (solid) that has not been melted by heating or the liquid crystalline polyol (melt) that has been melted by heating. The added amount by weight of the pyrolytic blowing agent is 0.02 to 0.20 times the weight of the liquid crystalline polyol, preferably 0.02 to 0.10 times. If the added amount of the pyrolytic blowing agent is less than 0.02 times, the number of bubbles generated is small, and the proportion of the bubbles in the matrix is low, and therefore, the hardness of the liquid crystalline polyurethane is great, so that the liquid crystalline polyurethane is unlikely to have good elasticity. If the added amount of the pyrolytic blowing agent exceeds 0.20 times, the proportion of the bubbles in the matrix is high, and therefore, the durability of the liquid crystalline polyurethane is likely to be low. Next, an isocyanate compound as a curing agent is added, and stirred for a predetermined period of time until the isocyanate compound is homogeneously mixed (S2). The added amount by weight of the isocyanate compound is 0.15 to 0.45 times the weight of the liquid crystalline polyol, preferably 0.20 to 0.40 times. If the added amount of the isocyanate compound is less than 0.15 times, polymerization by a urethane reaction is insufficient, and therefore, it is difficult to continuously mold the liquid crystalline polyurethane. If the added amount of the isocyanate compound exceeds 0.45 times, the blended amount of the mesogen group-containing compound in all the raw materials is relatively small, and therefore, the liquid crystalline polyurethane has difficulty in acquiring liquid crystallinity. Thus, by adding suitable amounts of a pyrolytic blowing agent and an isocyanate compound to the

liquid crystalline polyol to generate bubbles, the bubbles can have an average diameter (30 to 400 μm) suitable for the melt.

In the bubble generation step, a surfactant may also be added to the liquid crystalline polyol. When a surfactant is added, bubbles formed in the matrix have more uniform shapes, i.e., variations in the diameter of the bubbles are decreased.

<Cooling Step>

In the cooling step (S3), the melt containing the bubbles obtained in the bubble generation step (S1, S2) is cooled. The melt contains the mesogen groups having liquid crystallinity. Therefore, when the melt is cooled to a predetermined temperature that is higher than or equal to the glass transition temperature (Tg) and lower than or equal to the phase transition temperature (Ti), a liquid crystalline phase in which the mesogen groups can be aligned occurs in the matrix.

<Alignment Step>

In the alignment step (S4), the mesogen groups contained in the liquid crystalline polyurethane obtained in the cooling step (S3) are aligned. The alignment step (S4) is performed by stretching the liquid crystalline polyurethane while maintaining the liquid crystalline polyurethane at the above predetermined temperature. As a result, the mesogen groups contained in the liquid crystalline polyurethane are aligned in the stretching direction, resulting in high strength in the alignment direction. Note that the mesogen group can be aligned not only by stretching, but also by applying an electric field, magnetic field, or external light stimulus, which is selected, depending on the type of the liquid crystalline polyurethane or an additive.

The alignment properties of the liquid crystalline polyurethane can be determined by the degree of alignment. The mesogen groups having a high degree of alignment are more highly aligned in a uniaxial direction. The degree of alignment can be calculated on the basis of a predetermined calculation expression having, as parameters, the antisymmetric-stretching-vibrational absorbance (0°, 90°) of an aromatic ether and the symmetric-bending-vibrational absorbance (0°, 90°) of a methyl group, which are measured by a Fourier-transform infrared spectrometer (FT-IR). For example, germanium is used in the internal reflection element (IRE), and vertically-polarized light (S-polarized light) having an angle of incidence of 45° is used as measuring light, to measure these absorbances. The degree of alignment of the liquid crystalline polyurethane is calculated using the following calculation expression.

$$\text{Degree of alignment} = (A - B)/(A + 2B)$$

A: (the antisymmetric-stretching-vibrational absorbance of an aromatic ether as measured at 0°)/(the symmetric-bending-vibrational absorbance of a methyl group as measured at 0°)

B: (the antisymmetric-stretching-vibrational absorbance of an aromatic ether as measured at 90°)/(the symmetric-bending-vibrational absorbance of a methyl group as measured at 90°)

Note that, in order to cause a significant elasticity to occur in the thermoresponsive material, the degree of alignment of the liquid crystalline polyurethane is preferably 0.1 or more, more preferably 0.2 or more.

<Aging Step>

In the aging step (S5), the liquid crystalline polyurethane obtained in the alignment step (S4) is allowed to stand at a predetermined temperature or less for a predetermined period of time, in order to maintain the aligned state of the liquid crystalline polyurethane having high alignment properties. As a result, obtained is the liquid crystalline polyurethane in which the aligned state of the mesogen groups is maintained. The liquid crystalline polyurethane obtained by the method for producing the thermoresponsive material of the present invention can be used as a matrix for a thermoresponsive material having both liquid crystallinity and elasticity. Specifically, when the temperature of the liquid crystalline polyurethane, in which the mesogen groups are aligned in the stretching direction, exceeds the phase transition temperature (Ti) by heating, the mesogen groups are disaligned (irregularly oriented) and therefore the liquid crystalline polyurethane contracts in the stretching direction. When the liquid crystalline polyurethane is cooled to less than the phase transition temperature (Ti), the mesogen groups are realigned and therefore the liquid crystalline polyurethane expands in the stretching direction. Thus, the liquid crystalline polyurethane has such a specific responsive behavior. Therefore, the liquid crystalline polyurethane containing the aligned mesogen groups can be used as a thermoresponsive elastic material that is reversibly expandable in response to a change in temperature.

(Applications of Thermoresponsive Material)

The thermoresponsive material of the present invention can be used in various applications by utilizing the liquid crystallinity and elasticity of the liquid crystalline polyurethane as the matrix. Examples of such applications will be described.

The thermoresponsive material of the present invention is applicable to a heat control device. FIG. 2 is a diagram for describing a heat control device 10 that employs the thermoresponsive material. An illustration in a dashed-line circle shown in FIG. 2 is for describing the liquid crystalline polyurethane having mesogen groups 3 included in the thermoresponsive material, and bubbles 4 dispersed in the material. The illustration in the dashed-line circle is merely for illustrative purposes, and the liquid crystalline polyurethane and the bubbles 4 are not shown to scale.

The heat control device 10 is, for example, attached to an object 11 that is heat-controlled. The heat control device includes a heat dissipation plate 12, a heat conductive member 13, and a support member 14. The heat dissipation plate 12 has the function of receiving heat transferred from the object 11 to the heat conductive member 13 and dissipating the heat to the outside. The heat conductive member 13, which is attached to the heat dissipation plate 12, is configured such that the heat conductive member 13 can be brought into contact with and separated from the object 11. The support member 14, which is provided between the object 11 and the heat dissipation plate 12, supports the heat dissipation plate 12 and the heat conductive member 13 with respect to the object 11.

In the heat control device 10, the thermoresponsive material of the present invention is used in the support member 14. As shown in FIG. 2(a), when the heat control device 10 is in an environment the temperature of which is less than the phase transition temperature (Ti) of the liquid crystalline polyurethane, and as shown by the illustration in the dashed-line circle, the thermoresponsive material included in the support member 14 contains a liquid crystalline phase, the support member 14 expands. Therefore, the heat conductive member 13 is separated from the object 11, and therefore, heat is not transferred from the object 11 to the heat dissipation plate 12. Meanwhile, as shown in FIG. 2(b), when the heat control device 10 is in an environment the temperature of which exceeds the phase transition temperature (Ti) of the liquid crystalline polyurethane, and as shown by the illustration in the dashed-line circle, the thermoresponsive material included in the support member 14 contains an isotropic phase, the support member 14 contracts. Therefore, the heat conductive member 13 is in contact with the object 11, and therefore, heat is transferred from the object 11 to the heat dissipation plate 12. Therefore, by designing the heat control device 10 so that the phase transition temperature (Ti) of the liquid crystalline polyurethane used in the support member 14 of the heat control device 10 falls within the temperatures of the environment in which the heat control device 10 is placed, the object 11 can be suitably heat-controlled.

As shown in FIGS. 2(a) and 2(b), the bubbles 4, which are dispersed in the matrix 2, are deformed, depending on the deformation of the matrix 2. The bubbles 4 contribute to an improvement in the elasticity and flexibility of the matrix 2. The bubbles 4 have an average diameter of 30 to 400 $\mu$m. Therefore, even when the matrix 2 of the thermoresponsive material 1 is repeatedly caused to expand and contract, the bubbles 4 can flexibly expand and contract without initiating the rupture of the matrix 2. Therefore, the durability of the heat control device 10 is improved. Thus, the heat control device 10, which includes the thermoresponsive material 1, can repeatedly expand and contract, and can have excellent thermoresponsiveness, and therefore, is useful. In addition, the thermoresponsive material 1 has excellent durability, and therefore, the heat control device 10 can be used as a thermoresposive actuator, for example.

Incidentally, when the heat control device 10 transitions from the state of FIG. 2(a) to the state of FIG. 2(b), the mesogen groups 3 in the liquid crystalline polyurethane are irregularly oriented due to the increase in temperature, resulting in a decrease in the elasticity modulus and rupture stress of the support member 14. Therefore, there is a fear that the strength or durability of the heat control device 10 could be insufficient. However, in the state of FIG. 2(b), the heat conductive member 13 is in contact with the object 11, and therefore, the heat conductive member 13 can share stress with the support member 14. Thus, even if the temperature increase decreases the elasticity modulus or rupture stress of the support member 14, the decrease can be compensated for by the heat conductive member 13. As a result, the strength of the entire heat control device 10 can be maintained.

Examples

To verify the usefulness of the thermoresponsive material of the present invention, thermoresponsive materials having varied contents of raw materials were produced, and characteristics thereof were evaluated. Examples of the thermoresponsive material will now be described.

(Synthesis of Liquid Crystalline Polyurethane)

Liquid crystalline polyurethanes that would be used in the matrices of the thermoresponsive materials were synthesized (Examples 1 to 4 and Comparative Examples 1 to 3). Each liquid crystalline polyurethane was synthesized

as follows: initially, a liquid crystalline polyol (a mesogen diol A (BH6-PO4) or a mesogen diol B (BH6-PO6)) that is a precursor of the liquid crystalline polyurethane was synthesized; and then, the liquid crystalline polyol was reacted with an isocyanate compound. The blended amounts of the raw materials for the production of the thermoresponsive materials are shown in Table 1 below. Although, in the examples and comparative examples, the unit of the blended amount of each raw material for a liquid crystalline polyurethane is "g," the blended amounts can herein be scaled up by any reasonable factor. In other words, the unit of the blended amount of each raw material for a liquid crystalline polyurethane may be replaced by "parts by weight."

(Synthesis of Mesogen Diol A (BH6-PO4))

As the liquid crystalline polyol, a mesogen diol A (BH6-PO4) (hereinafter simply referred to as the "mesogen diol A") was synthesized. One hundred grams of a biphenyl compound (BH6) as the mesogen group-containing compound, 3.8 g of potassium hydroxide, and 600 ml of N,N-dimethyl formamide as a solvent were put into a reaction container and then mixed, and 4 equivalents of propylene oxide as the alkylene oxide was added with respect to 1 mol of the biphenyl compound (BH6). The resultant mixture was caused to undergo a reaction under applied pressure at 120°C for 2 hours (addition reaction). Next, 3.0 g of oxalic acid was added to the reaction container to stop the addition reaction. Insoluble salts were removed from the reaction liquid by suction filtration. In addition, N,N-dimethyl formamide was removed from the reaction liquid by distillation under reduced pressure. Thus, the mesogen diol A was obtained. A synthesis scheme for the mesogen diol A is represented by formula (2). Note that the mesogen diol A shown in formula (2) is representative, and there may be various structural isomers thereof.

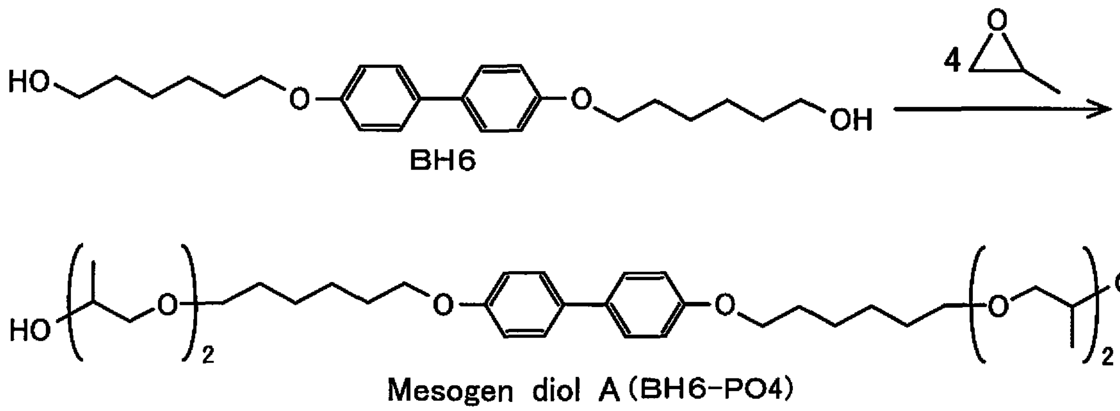


BH6

Mesogen diol A (BH6-PO4)

(2)

(Synthesis of Mesogen diol B (BH6-PO6))

As the liquid crystalline polyol, a mesogen diol B (BH6-PO6) (hereinafter simply referred to as the "mesogen diol B") was synthesized. The mesogen diol B was synthesized in a manner similar to that for the mesogen diol A, except that the added amount of propylene oxide was six equivalents with respect to one mole of a biphenyl compound (BH6). A synthesis scheme for the mesogen diol B is shown in formula (3). Note that the mesogen diol B shown in formula (3) is representative, and there may be various structural isomers thereof.

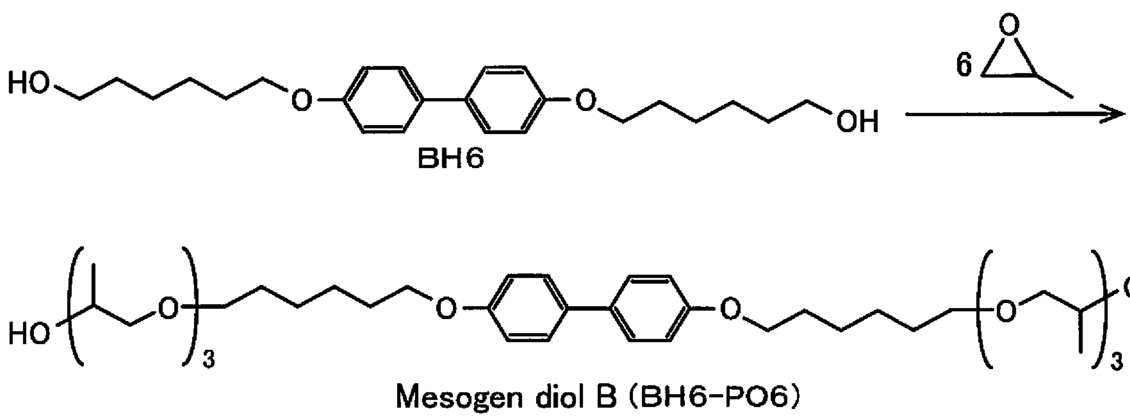


BH6

Mesogen diol B (BH6-PO6)

(3)

<Example 1>

One hundred grams of the mesogen diol A, 2.5 g of sodium hydrogen carbonate (manufactured by Nacalai Tesque, Inc.) as a pyrolytic blowing agent, and 0.25 g of tin octylate (T-9, manufactured by Toei Chemical Industry Co., Ltd.) as a catalyst were put into a reaction container and then mixed, and the temperature of the mixture was adjusted to 100°C so that the mesogen diol A was melted. Next, added was 32 g of an blended isocyanate (a mixture of HDI (manufactured by Nippon Polyurethane Industry Co., Ltd.) and Sumidur (registered trademark) N3300 (manufactured by Sumika Bayer Urethane Co., Ltd.), the weight ratio thereof being 8:2) as the isocyanate compound (curing agent), the temperature of which had been adjusted to 60°C, followed by stirring at 8000 rpm for 15 sec using a stirring device, to obtain a mixture. This mixture was loaded into a preheated mold, and then reacted and cured at 50°C for 30 min, to obtain a half-cured liquid crystalline urethane compound (pre-polymer). The liquid crystalline urethane compound was removed from the mold, followed by uniaxial stretching at 20°C and a stretch ratio of 2 times. Thereafter, the liquid crystalline urethane compound was completely cured at 20°C while the expanded state was maintained, to obtain a liquid crystalline polyurethane of Example 1 in which liquid crystal (mesogen groups) was aligned.

<Example 2>

A liquid crystalline polyurethane of Example 2 was obtained in a manner similar to that of Example 1 in terms of raw materials and their blended amounts, and reaction conditions, stretching conditions, and curing conditions, except that when the half-cured liquid crystalline urethane compound was obtained, the blended amount of sodium hydrogen carbonate was 5.0 g.

<Example 3>

A liquid crystalline polyurethane of Example 3 was obtained in a manner similar to that of Example 1 in terms of raw materials and their blended amounts, and reaction conditions, stretching conditions, and curing conditions, except that when the half-cured liquid crystalline urethane compound was obtained, the blended amount of sodium hydrogen carbonate was 5.0 g, and the blended amount of tin octylate was 0.10 g.

<Example 4>

A liquid crystalline polyurethane of Example 4 was obtained in a manner similar to that of Example 1 in terms of raw materials and their blended amounts, and reaction conditions, stretching conditions, and curing conditions, except that when the half-cured liquid crystalline urethane compound was obtained, the mesogen diol B was used as the liquid crystalline polyol, the blended amount of sodium hydrogen carbonate was 5.0 g, the blended amount of the blended isocyanate was 28 g, and the temperature for melting the mesogen diol B was adjusted to 80°C.

<Comparative Example 1>

A liquid crystalline polyurethane of Comparative Example 1 was obtained in a manner similar to that of Example 1 in terms of raw materials and their blended amounts, and reaction conditions, stretching conditions, and curing conditions, except that when the half-cured liquid crystalline urethane compound was obtained, 3 g of cyclopentane (manufactured by Tokyo Chemical Industry Co., Ltd.) was used as a blowing agent instead of sodium hydrogen carbonate, and this cyclopentane, the temperature of which had been adjusted to 40°C, was added to the blended isocyanate.

<Comparative Example 2>

A liquid crystalline polyurethane of Comparative Example 2 was obtained in a manner similar to that of Example 1 in terms of raw materials and their blended amounts, and reaction conditions, stretching conditions, and curing conditions, except that when the half-cured liquid crystalline urethane compound was obtained, the mesogen diol B was used as the liquid crystalline polyol, the blended amount of the blended isocyanate was 28 g, the blended amount of tin octylate was 0.50 g, the temperature for melting the mesogen diol B was adjusted to 80°C, 3 g of cyclopentane was used as a blowing agent instead of sodium hydrogen carbonate, and this cyclopentane, the temperature of which had been adjusted to 40°C, was added to the blended isocyanate.

<Comparative Example 3>

A liquid crystalline polyurethane of Comparative Example 3 was obtained in a manner similar to that of Example

1 in terms of raw materials and their blended amounts, and reaction conditions, stretching conditions, and curing conditions, except that when the half-cured liquid crystalline urethane compound was obtained, the mesogen diol B was used as the liquid crystalline polyol, the blended amount of the blended isocyanate was 28 g, the blended amount of tin octylate was 0.50 g, the temperature for melting the mesogen diol B was adjusted to 80°C, 3 g of cyclopentane was used as a blowing agent instead of sodium hydrogen carbonate, and this cyclopentane, the temperature of which had been adjusted to 40°C, was added to the blended isocyanate, and in addition, 0.1 g of water was added as a blowing agent when the tin octylate was added.

(Evaluation Method)

<Void Rate>

The liquid crystalline polyurethanes were each cut into a sample in the shape of a rectangular parallelepiped of 20 mm (height) × 20 mm (width) × 30 mm (length). The void rate of the sample was calculated by the following expression.

$$\text{Void rate (\%)} = V_1/V_2 \times 100$$

$V_1$: the volume of bubbles ($cm^3$)
$V_2$: the apparent volume of the sample calculated from the dimensions thereof ($cm^3$)

Here, $V_1$ was calculated from the difference between $V_2$ and $V_3$, where $V_3$ ($cm^3$) represents the actual volume of the sample that was measured using an air comparison pycnometer (model 930, manufactured by Beckman Instruments, Inc.) in accordance with ASTM-2856-94-C.

<Apparent Density>

The liquid crystalline polyurethanes were each cut into a sample in the shape of a cube of 50 mm × 50 mm × 50 mm, and the apparent density of the sample was measured in accordance with JIS K7222.

<Average Diameter of Bubbles and Standard Deviation of Diameters of Bubbles>

The liquid crystalline polyurethanes were each cut into parallel strips having a thickness of 1 mm or less using a razor blade, which were used as samples. Each sample was fixed together with a scale onto a microscope slide. A 100 times magnified image of the sample was captured using an SEM (S-3500N, manufactured by Hitachi Science Systems, Ltd.). The obtained image was processed using image processing software (two-dimensional image analyzing software "WinROOF," manufactured by Mitani Corporation) to detect bubbles from an arbitrary range, and trace the contours of the bubbles. The diameter of a bubble was defined as the diameter of an equivalent circle that was calculated from the perimeter of the traced figure. When the contour of a bubble is elliptical, the diameter of the bubble was defined as the diameter of an equivalent circle having the same area as that of the ellipse. An average "a" and a standard deviation "D" were calculated from the obtained diameters of the bubbles. The value D/a was used as a parameter indicating variations in the bubbles.

<Measurement of Phase Transition Temperature (Ti) from Liquid Crystalline Phase to Isotropic Phase>

The phase transition temperatures (Ti) of the liquid crystalline polyurethanes were each measured using a differential scanning calorimeter (DSC) (X-DSC 7000, manufactured by Hitachi High-Tech Science Corporation). During the measurement, the temperature was increased at a rate of 20°C/min.

<Recovery Rate>

The liquid crystalline polyurethanes were each cut into a sample in the shape of a rectangular parallelepiped of 10 mm (width) × 100 mm (length) × 10 mm (thickness). While tension was being applied to the sample in the alignment direction (expansion/contraction direction) so that an internal stress of 30 kPa occurred, the ambient temperature was repeatedly changed between 20°C and 80°C so that the liquid crystalline polyurethane expanded and contracted. After the temperature change cycle (expansion and contraction) was conducted 1,000 times, the durability of the thermoresponsive material was evaluated using a recovery rate represented by the following expression.

$$\text{Recovery rate (\%)} = S_2/S_1 \times 100$$

$S_1$: the expansion/contraction ratio of the sample in the first temperature change cycle
$S_2$: the expansion/contraction ratio of the sample in the 1,000th temperature change cycle

$$\text{Expansion/contraction ratio (\%)} = L_{20}/L_{80}$$

$L_{20}$: the length (mm) of the sample in the alignment direction when a load of 30 kPa was applied thereto at 20°C
$L_{80}$: the length (mm) of the sample in the alignment direction when a load of 30 kPa was applied thereto at 80°C

(Evaluation Results)

The evaluation results of the liquid crystalline polyurethanes of the examples and the comparative examples are shown in Table 1 below.

| | | Example1 | Example2 | Example3 | Example4 | Comparative Exemple1 | Comparative Example2 | Comparative Example3 |
|---|---|---|---|---|---|---|---|---|
| Liquid crystalline polyol | Mesogen diol A (g) | 100 | 100 | 100 | - | 100 | - | - |
| | Mesogen diol B (g) | - | - | - | 100 | - | 100 | 100 |
| Blowing agent | Sodium hydrogen carbonate (g) | 2.5 | 5.0 | 5.0 | 5.0 | - | - | - |
| | cyclopentane (g) | - | - | - | - | 3 | 3 | 3 |
| | Water (g) | - | - | - | - | - | - | 0.1 |
| Catalyst | T-9 (tin octylate) (g) | 0.25 | 0.25 | 0.10 | 0.25 | 0.25 | 0.50 | 0.50 |
| Curing agent | HDI(g) | 25.6 | 25.6 | 25.6 | 22.4 | 25.6 | 22.4 | 22.4 |
| | Sumidur N3300 (g) | 6.4 | 6.4 | 6.4 | 5.6 | 6.4 | 5.6 | 5.6 |
| Void rate (%) ($V_1/V_2 \times 100$) | | 37 | 65 | 83 | 75 | 65 | 68 | 75 |
| Apparent density ($g/cm^3$) | | 0.71 | 0.39 | 0.21 | 0.30 | 0.39 | 0.36 | 0.28 |
| Average diameter a of bubbles ($\mu$ m) | | 46 | 97 | 253 | 102 | 940 | 510 | 760 |
| Standard deviation D of diameters of bubbles ($\mu$ m) | | 25 | 45 | 135 | 46 | 690 | 540 | 610 |
| Standard deviation of diameters of bubbles/ average diameter of bubbles (D/a) | | 0.543 | 0.464 | 0.534 | 0.451 | 0.734 | 1.059 | 0.803 |
| Phase transition temperature Ti (° C) | | 45 | 45 | 46 | 31 | 44 | 31 | 30 |
| Recovery rate (%) | | 97 | 97 | 97 | 97 | 0 (Rupture) | 0 (Rupture) | 0 (Rupture) |

As shown in Table 1, in Examples 1 to 4, the average diameters of bubbles in the matrices of the thermoresponsive materials were within the range of 30 to 400 μm as specified herein. The ratio (D/a) of the standard deviation D to the average a of the diameters of the bubbles was 0.7 or less. The void rates (%) of the thermoresponsive materials were 37 to 83% ($V_1/V_2$ = 0.37 to 0.83). Thus, in Examples 1 to 4, it was demonstrated that the sizes of the bubbles were maintained small in the matrix, and variations in bubble size were small. It was also demonstrated that the recovery rates of the thermoresponsive materials were as high as 97%, and therefore, the durability of the thermoresponsive materials were sufficiently enhanced.

In contrast to this, in Comparative Examples 1 to 3, the average diameters of bubbles contained in the matrices of the thermoresponsive materials were 500 μm or more. The ratio (D/a) of the standard deviation D to the average a of the bubbles exceeded 0.7. Thus, in Comparative Examples 1 to 3, it was observed that a portion of the bubbles in the matrix tended to be excessively large (swelled), and variations in bubble size also tended to be large. In addition, when the temperature change (expansion and contraction) was repeatedly conducted, the thermoresponsive materials were ruptured (recovery rate: 0%) before the number of temperature change cycles reached 1,000. Therefore, the durability of the thermoresponsive materials was not practical.

FIG. 3 shows electron microscopic photographs of representative thermoresponsive materials of the present invention. FIG. 3(a) is a photograph of the thermoresponsive material of Example 1 that was taken in an environment the temperature of which was less than the phase transition temperature (Ti) of the liquid crystalline polyurethane. FIG. 3(b) is a photograph of the thermoresponsive material of Example 2 that was taken in a similar environment. In both of the thermoresponsive materials of Examples 1 and 2, in an environment the temperature of which was less than the phase transition temperature (Ti), significant variations in bubble size that could have caused a decrease in the strength of the material were not observed, and no bubbles having a diameter of 500 μm or more were observed.

INDUSTRIAL APPLICABILITY

Thanks to its excellent thermoresponsiveness, elasticity, and durability, the thermoresponsive material of the present invention can be used in various applications in addition to a heat control device that has been described in the above embodiments. For example, the thermoresponsive material is applicable to industrial fields such as actuators and filters. The thermoresponsive material is also applicable to medical and health care fields such as artificial muscles and catheters.

REFERENCE SIGNS LIST

1 THERMORESPONSIVE MATERIAL

2 MATRIX (LIQUID CRYSTALLINE POLYURETHANE)

3 MESOGEN GROUP

4 BUBBLES

10 HEAT CONTROL DEVICE

11 OBJECT TO BE HEAT-CONTROLLED

12 HEAT DISSIPATION PLATE

13 HEAT CONDUCTIVE MEMBER

14 SUPPORT MEMBER (THERMORESPONSIVE MATERIAL)

**Claims**

**1.** A thermoresponsive material whose state changes, depending on a change in temperature, **characterized in that** it comprises:

a matrix in which bubbles having an average diameter of 30 to 400 μm are dispersed.

2. The thermoresponsive material according to claim 1, **characterized in that** $D/a \leq 0.7$ is satisfied, where D represents the standard deviation of diameters of the bubbles, and a represents the average diameter of the bubbles.

3. The thermoresponsive material according to claim 1 or 2, **characterized in that** $0.3 \leq V_1/V_2 \leq 0.9$ is satisfied, where $V_1$ represents the volume of the bubbles at room temperature, and $V_2$ represents the apparent volume of the matrix at room temperature.

4. The thermoresponsive material according to any one of claims 1 to 3, **characterized in that** the matrix contains a liquid crystalline polyurethane.

5. The thermoresponsive material according to claim 4, **characterized in that** the liquid crystalline polyurethane has mesogen groups aligned by stretching, and when the temperature of the liquid crystalline polyurethane exceeds a phase transition temperature (Ti) of the liquid crystalline polyurethane, the mesogen groups are disaligned, and the liquid crystalline polyurethane contracts in a stretching direction, and when the temperature of the liquid crystalline polyurethane is less than the phase transition temperature (Ti), the mesogen groups are realigned, and the liquid crystalline polyurethane expands in the stretching direction.

6. A method for producing a thermoresponsive material whose state changes, depending on a change in temperature, **characterized in that** the method comprises:

   a bubble generation step of adding a pyrolytic blowing agent to a liquid crystalline polyol that has or has not been melted by heating, the weight ratio of the pyrolytic blowing agent to the liquid crystalline polyol being 0.02 to 0.20 times, and adding an isocyanate compound to the liquid crystalline polyol that has been melted by heating, the weight ratio of the isocyanate compound to the liquid crystalline polyol being 0.15 to 0.45 times, to generate bubbles in the melt of the liquid crystalline polyol; and
   a cooling step of cooling the melt containing the bubbles to form a liquid crystalline polyurethane.

7. The method according to claim 6, **characterized in that** it further comprises:

   an alignment step of aligning mesogen groups contained in the liquid crystalline polyurethane; and
   an aging step of maintaining an aligned state of the mesogen groups.

8. The method according to claim 6 or 7, **characterized in that** in the bubble generation step, sodium hydrogen carbonate is added as the pyrolytic blowing agent.

9. A heat control device **characterized in that** it comprises:

   the thermoresponsive material according to any one of claims 1 to 5.

10. The heat control device according to claim 9, **characterized in that** it comprises:

   a heat conductive member configured to be brought into contact with or separated from an object to be heat-controlled;
   a heat dissipation plate configured to receive heat transferred from the object to the heat conductive member, and dissipate the heat to the outside; and
   a support member provided between the object and the heat dissipation plate, and configured to support the heat dissipation plate and the heat conductive member with respect to the object, and
   the support member contains the thermoresponsive material, and is configured such that when the support member contracts in response to a change in temperature, the heat conductive member is brought into contact with the object.

[FIG. 1]

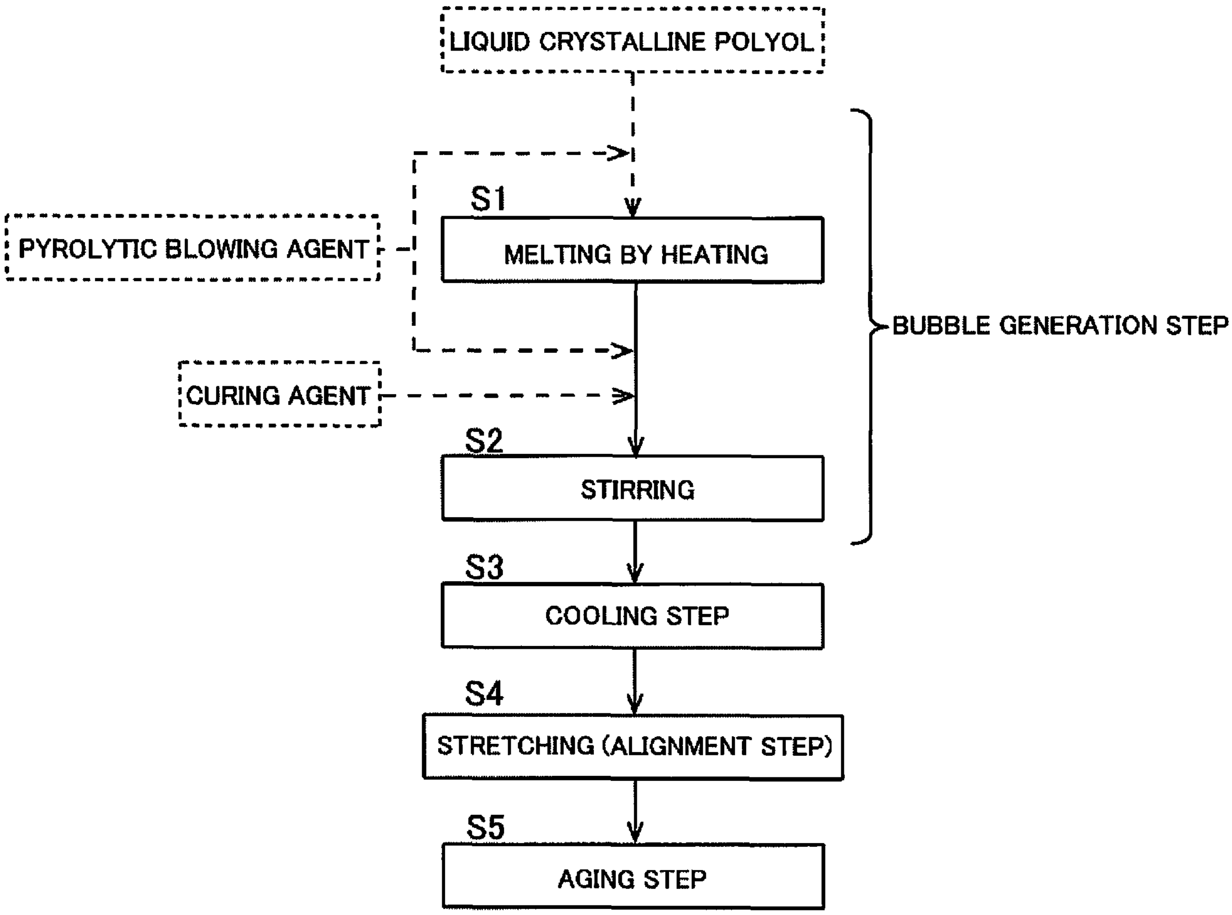
LIQUID CRYSTALLINE POLYOL
PYROLYTIC BLOWING AGENT
S1
MELTING BY HEATING
CURING AGENT
S2
STIRRING
BUBBLE GENERATION STEP
S3
COOLING STEP
S4
STRETCHING (ALIGNMENT STEP)
S5
AGING STEP

[FIG. 2]

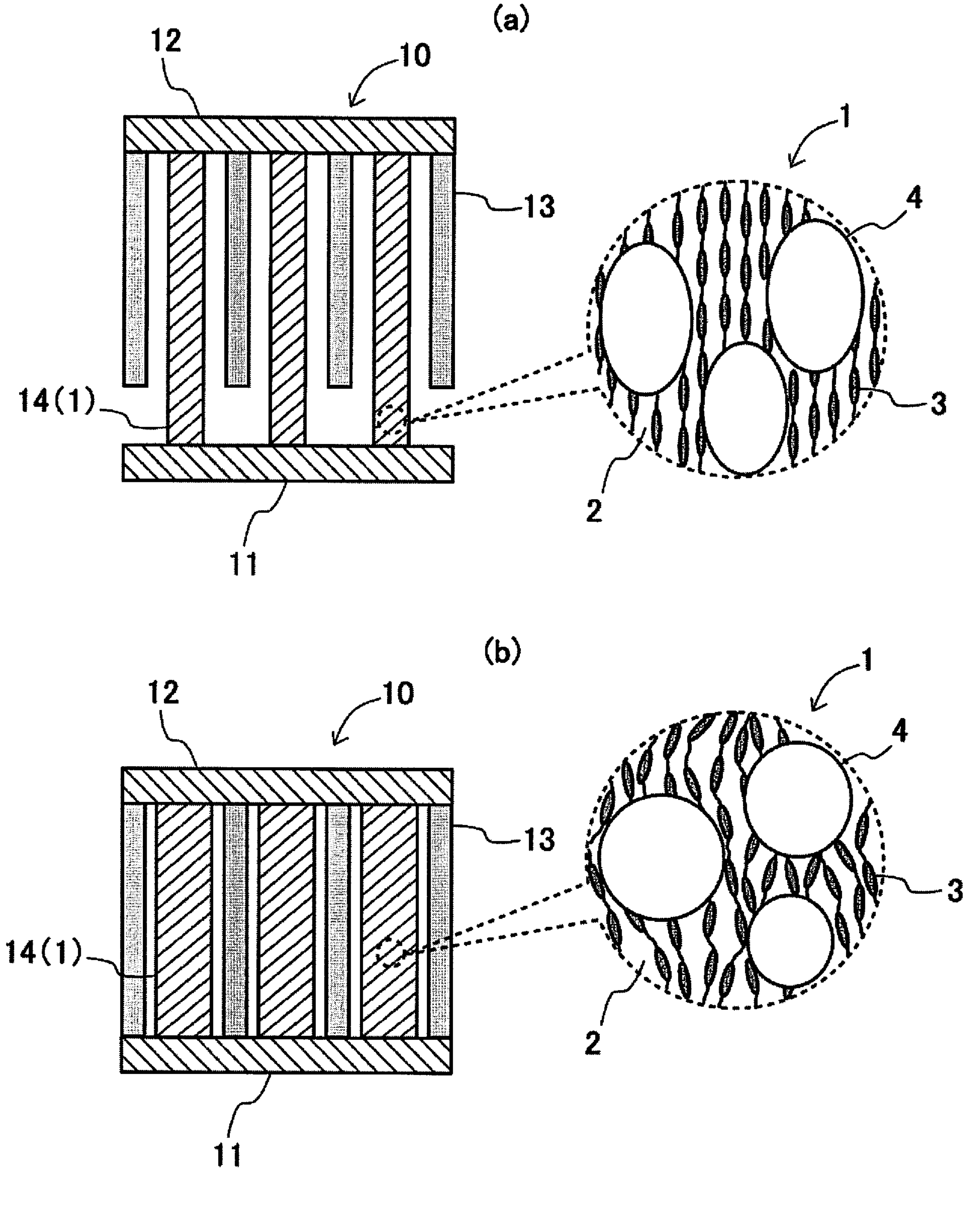

[FIG. 3]

(a)

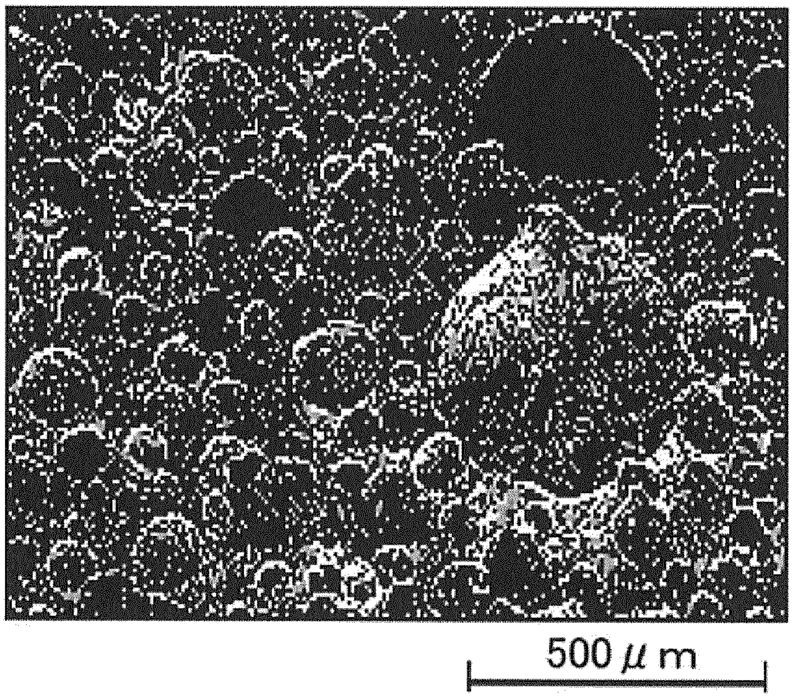


(b)

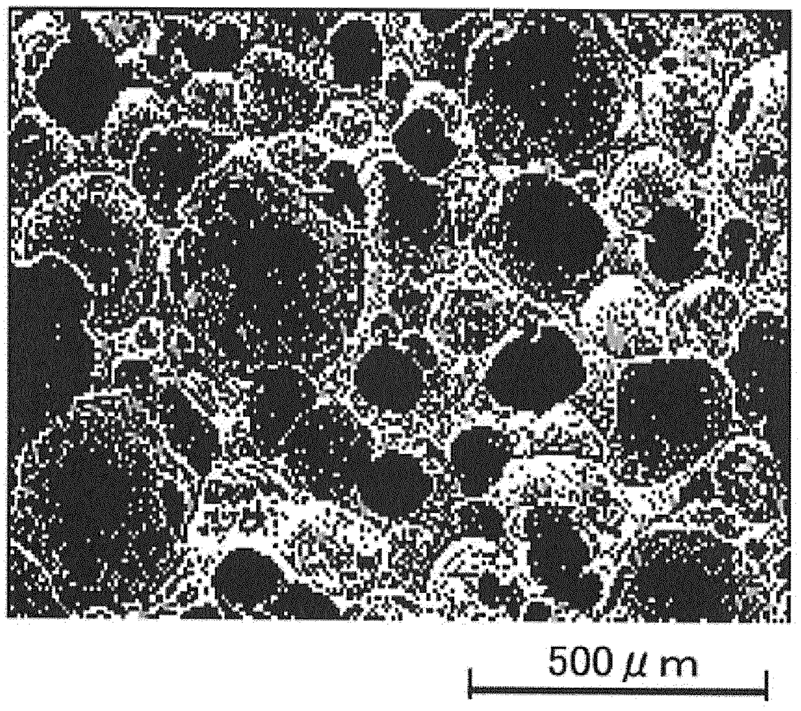

## INTERNATIONAL SEARCH REPORT

International application No.
PCT/JP2016/081845

A. CLASSIFICATION OF SUBJECT MATTER
*C08J9/08*(2006.01)i, *B29C44/00*(2006.01)i, *C08G18/32*(2006.01)i, *C08L101/00*(2006.01)i, *C08G101/00*(2006.01)n

According to International Patent Classification (IPC) or to both national classification and IPC

B. FIELDS SEARCHED

Minimum documentation searched (classification system followed by classification symbols)
C08J9/08, B29C44/00, C08G18/32, C08L101/00, C08G101/00

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2016 |
| Kokai Jitsuyo Shinan Koho | 1971-2016 | Toroku Jitsuyo Shinan Koho | 1994-2016 |

Electronic data base consulted during the international search (name of data base and, where practicable, search terms used)
CAplus/REGISTRY(STN)

C. DOCUMENTS CONSIDERED TO BE RELEVANT

| Category* | Citation of document, with indication, where appropriate, of the relevant passages | Relevant to claim No. |
|---|---|---|
| X<br>A | JP 2013-89767 A (Fujibo Holdings, Inc.),<br>13 May 2013 (13.05.2013),<br>claims<br>& US 2014/0242894 A1<br>claims<br>& WO 2013/058183 A1 & EP 2806453 A1<br>& CN 103930975 A | 1-2,9<br>3-8,10 |
| X<br>A | JP 2013-14658 A (Sanyo Chemical Industries, Ltd.),<br>24 January 2013 (24.01.2013),<br>claims; paragraphs [0140] to [0142]<br>(Family: none) | 6<br>1-5,7-10 |
| A | JP 63-22820 A (The Dow Chemical Co.),<br>30 January 1988 (30.01.1988),<br>& US 4745135 A1 & EP 260388 A2 | 1-10 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 13 December 2016 (13.12.16) | 20 December 2016 (20.12.16) |

| Name and mailing address of the ISA/ | Authorized officer |
|---|---|
| Japan Patent Office<br>3-4-3,Kasumigaseki,Chiyoda-ku,<br>Tokyo 100-8915,Japan | Telephone No. |

Form PCT/ISA/210 (second sheet) (January 2015)

**INTERNATIONAL SEARCH REPORT**

International application No.
PCT/JP2016/081845

C (Continuation). DOCUMENTS CONSIDERED TO BE RELEVANT

| Category* | Citation of document, with indication, where appropriate, of the relevant passages | Relevant to claim No. |
|---|---|---|
| A | Dong-Jin Lee, Toshiyuki Uryu, Synthesis of Enantiotropic Liquid Crystal Copolyurethanes Containing Para- and Meta-Type Diisocyanate Units in the Backbone, Macromolecules, 1998.09.26, Vol.31, No.21, pp.7142-7148 | 1-10 |

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2006134697 A